# EUROPÄISCHE PATENTSCHRIFT

(11) **EP 2 018 672 B1**
(45) Veröffentlichungstag und Bekanntmachung des Hinweises auf die Patenterteilung: **15.12.2010**
(21) Anmeldenummer: 07728210.1
(22) Anmeldetag: 18.04.2007
(51) Int. Cl.: F02M 63/00, H01L 41/053, F02M 47/02

(54) **INJEKTOR MIT EINEM PIEZOELEKTRISCHEN AKTOR FÜR EINE BRENNKRAFTMASCHINE**
INJECTOR COMRISING A PIEZOELECTRIC ACTUATOR FOR AN INTERNAL COMBUSTION ENGINE
INJECTEUR MUNI D'UN ACTIVATEUR PIÉZOÉLECTRIQUE POUR MOTEUR À COMBUSTION INTERNE

(30) Priorität: 11.05.2006 DE 102006021945
(43) Veröffentlichungstag der Anmeldung: 28.01.2009
(73) Patentinhaber: Robert Bosch GmbH, 70442 Stuttgart (DE)
(72) Erfinder: SEBASTIAN, Thomas, 71729 Erdmannhausen (DE); SASSEN, Klaus, 71672 Marbach/N. (DE); BOECKING, Friedrich, 70499 Stuttgart (DE)
(86) Internationale Anmeldenummer: PCT/EP2007/053748
(87) Internationale Veröffentlichungsnummer: WO 2007/131857

(56) Entgegenhaltungen:
- EP-A1- 0 144 655
- DE-A1- 19 818 068
- DE-A1- 19 914 411
- DE-A1-102004 012 863
- DE-A1-102004 018 100
- US-A- 4 553 059

## Beschreibung

Die Erfindung geht aus von einem piezoelektrischen Injektor nach der Gattung des Hauptanspruchs.

Es sind beispielsweise aus der DE 198 38 862 A1 schon Piezoaktoren bekannt mit piezoelektrischen Keramikschichten, die übereinander zu einem Multilayerstapel geschichtet angeordnet sind, wobei zwischen den piezoelektrischen Keramikschichten jeweils eine Elektrodenschicht vorgesehen ist. Die Elektrodenschichten sind über eine erste Außenelektrode und eine zweite Außenelektrode mit einer Stromversorgung verbunden.

Piezoaktoren werden von einem Steuergerät mit hoher Frequenz vorteilhafterweise getaktet angesteuert. Durch die schnellen Schaltvorgänge entstehen erhebliche elektromagnetische Störungen, die durch aufwendige Maßnahmen am Steuergerät oder den elektrischen Zuleitungen der Piezoaktoren verringert werden müssen.

Der Erfindung liegt die Aufgabe zugrunde, einen piezoelektrischen Injektor mit einem piezoelektrischen Aktor mit verbesserter elektromagnetischer Verträglichkeit (EMV) bereitzustellen.

### Vorteile der Erfindung

Dadurch, dass der Aktorkopf und/oder der Aktorfuß aus einem keramischen Material hergestellt werden, verringert sich die Kapazität des zwischen der elektrischen Masse und dem Piezoaktor gebildeten elektrischen Kondensators. Dadurch wird die Intensität der beim Schalten des Piezoaktors entstehenden Störsignale stark reduziert und somit die elektromagnetische Verträglichkeit des erfindungsgemäßen piezoelektrischen Aktors verbessert.

Beispielsweise werden der Aktorkopf und der Aktorfuß aus einem keramischen Material mit möglichst geringer Dielektrizitätskonstante gewählt. Als besonders vorteilhafter Werkstoff hat sich beispielsweise Aluminiumoxid erwiesen. Ein weiterer Vorteil des piezoelektrischen Aktors besteht darin, dass keine zusätzlichen Bauteile erforderlich werden, so dass die Zahl der Bauteile nicht zunimmt. Durch den Wechsel von metallischen Werkstoffen zu keramischen Werkstoffen wird außerdem die Steifigkeit des piezoelektrischen Aktors erhöht, da keramische Werkstoffe einen wesentlich größeren Elastizitätsmodul als Metalle haben.

Da auch der piezoelektrische Aktor selbst aus einem keramischen Werkstoff besteht, ist es fertigungstechnisch relativ einfach möglich, die Herstellung der von Aktorkopf und Aktorfuß in den Herstellungsprozess des piezoelektrischen Aktors zu integrieren. Somit wird die Herstellung des Aktors vereinfacht und es entstehen in der Gesamtherstellungskette keine zusätzlichen Montageschritte.

Eine Ausgestaltung sieht vor, dass die Piezoelektrodenschichten des piezoelektrischen Aktors durch zwei Außenelektroden kontaktiert sind, und dass die Außenelektroden zwischen eine Stirnseite des Aktors und das Fußteil geführt sind. Dadurch ist es auf einfache Weise möglich, insbesondere die Enden der Außenelektroden vor mechanischen Beschädigungen zu schützen.

Eine Weiterbildung dieser Ausführungsform sieht vor, dass in dem Fußteil mindestens eine Kabelführung vorgesehen ist, und dass die elektrischen Leitungen in der oder den Kabelführungen verlaufen. Dadurch ist es möglich, den piezoelektrischen Aktor auf einfache Weise an die Stromversorgung anzuschließen. Diese Art der Stromversorgung bzw. der Kontaktierung der Außenelektroden ist extrem robust und somit auch sehr zuverlässig.

Der piezoelektrische Aktor kann bezüglich seiner elektromagnetischen Verträglichkeit weiter verbessert werden, wenn der Aktor von einem elastischen und flüssigkeitsdichten Mantel umgeben ist, wobei dieser Mantel dichtend mit dem Kopfteil und mit dem Fußteil verbunden ist. Dadurch kann ein geschlossenes Metallgehäuse entfallen und die von dem piezoelektrischen Aktor ausgehenden Störsignale werden weiter reduziert. Gleichzeitig wird der Bauaufwand für die Abdichtung des piezoelektrischen Aktors gegen Kraftstoff vereinfacht.

Ausgestaltungen des piezoelektrischen Aktors sehen vor, dass das Kopfteil und/oder das Fußteil eine oder mehrere Umfangsnuten aufweisen, und dass der Mantel formschlüssig mit der oder den Umfangsnuten verbunden ist. Dadurch ergibt sich eine sehr belastbare und auch dauerfeste flüssigkeitsdichte Verbindung des Mantels mit dem Aktorkopf und dem Aktorfuß.

Der Mantel kann durch Umspritzen des Aktors, des Kopfteils und des Fußteils mit Gummi oder Kunststoff hergestellt werden.

Alternativ ist es auch möglich, dass der Mantel aus einem Schrumpfschlauch hergestellt wird. Dazu wird einen Schrumpfschlauch über Aktorfuß, piezoelektrischen Aktor und Aktorkopf gezogen und anschließend erwärmt. Durch das Erwärmen zieht sich der Schrumpfschlauch zusammen und bildet einen flüssigkeitsdichten Mantel.

Die eingangs genannte Aufgabe wird erfindungsgemäß bei einem Injektor für ein Kraftstoffeinspritzsystem einer Brennkraftmaschine, mit einem Gehäuse, wobei in dem Gehäuse ein piezoelektrischer Aktor, ein hydraulisches Steuerventil und ein Düsenmodul mit einer Düsennadel angeordnet sind, wobei sich der piezoelektrische Aktor einenends mindestens mittelbar gegen das Gehäuse abstützt, wobei sich der piezoelektrische Aktor anderenends mindestens mittelbar gegen das Steuerventil abstützt und wobei zwischen piezoelektrischem Aktor und Steuerventil eine Einstellplatte vorgesehen ist, dadurch gelöst, dass die Einstellplatte aus einem keramischen Material besteht.

Die Einstellplatte dient vorteilhaft dazu, Längentoleranzen in dem Injektor auszugleichen und den Hub des piezoelektrischen Aktors einzustellen. Auch hier kann durch den Wechsel des Werkstoffs von einem metallischen Werkstoff zu einem keramischen Werkstoff die elektromagnetische Verträglichkeit des Injektors erhöht werden, ohne dass die Zahl der Bauteile ansteigt. Gleichzeitig wird wegen der höheren Steifigkeit der keramischen Einstellplatte die Übertragung des Hubs des Piezoaktors auf das Steuerventil verbessert. Dadurch verbessert sich auch das Betriebsverhalten des erfindungsgemäßen Injektors.

Weil keramische Werkstoffe in der Regel auch ein geringeres spezifisches Gewicht als Metall, insbesondere Stahl, haben, wird durch den Wechsel des Werkstoffs auch die Massenträgheit der bewegten Teile des Injektors reduziert, was sich vorteilhaft auf die Dynamik des Injektors auswirkt.

Die elektromagnetische Verträglichkeit des erfindungsgemäßen Injektors wird weiter verbessert, wenn zwischen dem piezoelektrischen Aktor und dem Gehäuse ein Distanzstück aus einem keramischen Material vorgesehen wird.

Auch dadurch wird die Steifigkeit innerhalb des erfindungsgemäßen Injektors erhöht und gleichzeitig die elektromagnetische Verträglichkeit verbessert.

Eine Ausgestaltung des Injektors sieht vor, dass der piezoelektrische Aktor ein Aktor nach der voranstehenden Beschreibung ist. Dadurch lassen sich die Maßnahmen kombinieren und deren Wirkung zumindest teilweise addieren. Im Ergebnis entsteht dadurch ein Injektor mit einer sehr guten elektromagnetischen Verträglichkeit. Dadurch können aufwendige Maßnahmen zur Unterdrückung der Störsignale des vom piezoelektrischen Aktor ausgehenden Störsignals entfallen oder zumindest durch sehr viel einfachere und kostengünstigere Alternativmaßnahmen ersetzt werden.

Allen erfindungsgemäß vorgeschlagenen Maßnahmen ist gemeinsam, dass die Zahl der Bauteile nicht erhöht wird und infolge dessen kein zusätzlicher Herstellungs- und Montageaufwand entsteht.

Des Weiteren benötigen die erfindungsgemäßen Maßnahmen keinen zusätzlichen Bauraum, was einen weiteren sehr wichtigen Vorteil darstellt. Infolgedessen ist es auch häufig möglich, bereits in Serie gefertigte Injektoren ohne größere konstruktive Änderungen ganz oder teilweise umzurüsten. Beispielsweise können die Einstellplatten ohne konstruktive Änderungen durch keramische Einstellplatten ersetzt werden. Gleiches gilt für die Distanzstücke zwischen dem Aktor und dem Gehäuse. Selbstverständlich ist es auch möglich, in herkömmliche Piezoinjektoren den beschriebenen piezoelektrischen Aktor einzubauen. Auch hier sind keine konstruktiven Änderungen am Gehäuse des Injektors sowie am Steuerventil oder am Düsenmodul erforderlich.

Weitere Vorteile und vorteilhafte Ausgestaltungen der Erfindung sind der nachfolgenden Zeichnung, deren Beschreibung und den Patentansprüchen entnehmbar. Alle in der Zeichnung, deren Beschreibung in den Patentansprüchen offenbarten Merkmale können sowohl einzeln als auch in beliebiger Kombination miteinander erfindungswesentlich sein.

### Zeichnungen

Es zeigen:
- Figur 1: einen Längsschnitt eines erfindungsgemäßen Injektors und
- Figur 2: einen Längsschnitt eines piezoelektrischen Aktors im Teillängsschnitt.

### Beschreibung der Ausführungsbeispiele

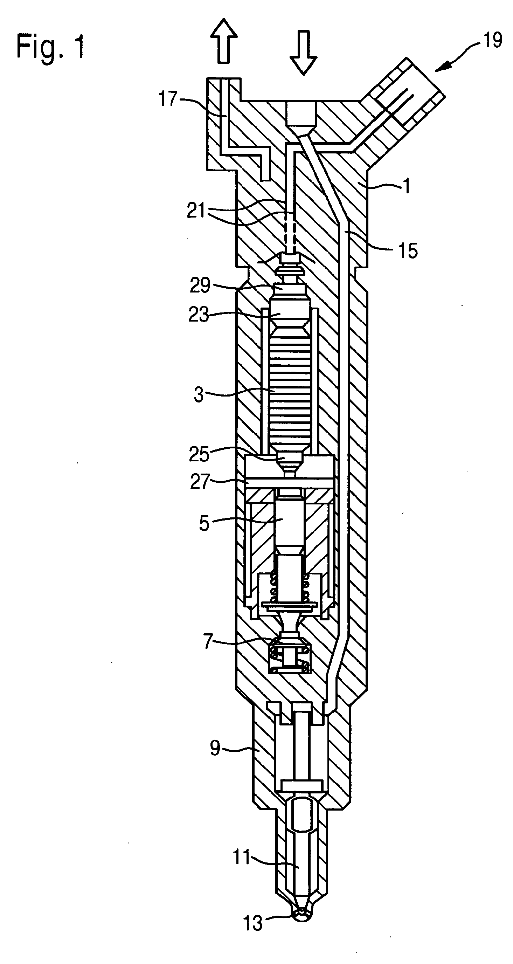

In Figur 1 ist ein Piezoaktor im Längsschnitt stark vereinfacht dargestellt. Der Piezoaktor weist ein Gehäuse 1 auf. In dem Gehäuse 1 sind ein piezoelektrischer Aktor 3, ein hydraulischer Koppler 5, ein Steuerventil 7 sowie ein Düsenmodul 9 mit einer Düsennadel 11 mit mehreren Spritzlöchern 13 aufgenommen. In dem Gehäuse 1 des erfindungsgemäßen sind weiter ein Hochdruckanschluss 15, eine Leckageabfuhr 17 und eine Stromversorgung 19 vorhanden.

Über die Stromversorgung 19 ist der Injektor mit einem nicht dargestellten Steuergerät verbunden. Wenn der piezoelektrische Aktor 3 angesteuert werden soll, wird an die Stromversorgung 19 von einem Motorsteuergerät (nicht dargestellt) eine elektrische Spannung angelegt. Die Stromversorgung 19 ist über elektrische Leitungen 21 mit dem piezoelektrischen Aktor 3 verbunden. Dadurch ist es möglich, durch Ansteuern der Stromversorgung 19 den piezoelektrischen Aktor 3 zu aktivieren. Die Details der elektrischen Kontaktierung des piezoelektrischen Aktors sind in Figur 1 nicht dargestellt.

Der Piezoaktor 3 stützt sich mit seinem in Figur 1 oberen Ende über ein Fußteil 23 gegen das Gehäuse 1 des Piezoaktors ab. Beispielsweise wird dieses Fußteil 23 aus einem keramischen Werkstoff mit möglichst Dielektrizitätskonstante hergestellt. Ein geeigneter keramischer Werkstoff ist beispielsweise Aluminiumoxid.

Unterhalb des piezoelektrischen Aktors 3 ist ein Kopfteil 25 angeordnet, welches den Aktorhub über eine Einstellplatte 27 auf den hydraulischen Koppler 5 überträgt. Beispielsweise werden auch das Kopfteil und/oder erfindungsgemäß die Einstellplatte 25 aus einem keramischen Werkstoff mit niedriger Dielektrizitätskonstante hergestellt. Das Ersetzen des Fußteils 23, des Kopfteils 25 und der Einstellplatte 27, die üblicherweise aus Stahl hergestellt werden, durch Werkstücke aus einem keramischen Material mit niedriger Dielektrizitätskonstante führt dazu, dass der durch den piezoelektrischen Aktor 3 und die elektrische Masse des Fahrzeugs, in der der erfindungsgemäße Injektor eingebaut wird, gebildete Kondensator in seiner Kapazität drastisch verringert wird. Dadurch werden auch die Störsignale, die durch das hochfrequente Ansteuern des piezoelektrischen Aktors 3 über die elektrische Masse in das Fahrzeug eingebracht werden, drastisch reduziert. Infolgedessen verbessert sich die elektromagnetische Verträglichkeit des piezoelektrischen Aktors. Besonders vorteilhaft an dieser Lösung ist, dass die Ursache der Störsignale wirksam bekämpft wird und infolgedessen auf aufwendige Maßnahmen, sei es im Kabelbaum oder im Steuergerät der Brennkraftmaschine, ganz oder teilweise verzichtet werden kann.

Ein weiterer wesentlicher Vorteil der Erfindung ist darin zu sehen, dass die erfindungsgemäßen Maßnahmen keinen zusätzlichen Bauraum erfordern und auch die Zahl der Bauteile nicht erhöht wird. Schließlich ist noch darauf hinzuweisen, dass die keramischen Werkstoffe einen sehr viel höheren Elastizitätsmodul als Stahl oder andere metallische Werkstoffe haben, so dass die Steifigkeit der erfindungsgemäßen Anordnung, bestehend aus Fußteil 23, Kopfteil 25, piezoelektrischem Aktor 3 und Einstellplatte 27 erhöht wird. Dadurch verbessert sich die Dynamik des piezoelektrischen Aktors bzw. des mit diesem Aktor ausgerüsteten Injektors und der wirksame Hub des piezoelektrischen Aktors bzw. des Stellglieds (ohne Bezugszeichen) in dem Steuerventil 7 vergrößert sich.

Als zusätzliche Maßnahme kann weiter vorgesehen werden, dass oberhalb des Kopfteils 25 ein Distanzstück 29 vorgesehen ist. Das Distanzstück 29 ist zwischen dem Gehäuse 1 des Injektors und dem Fußteil 23 des Injektors angeordnet und besteht ebenfalls aus einem keramischen Material mit geringer Dielektrizitätskonstante.

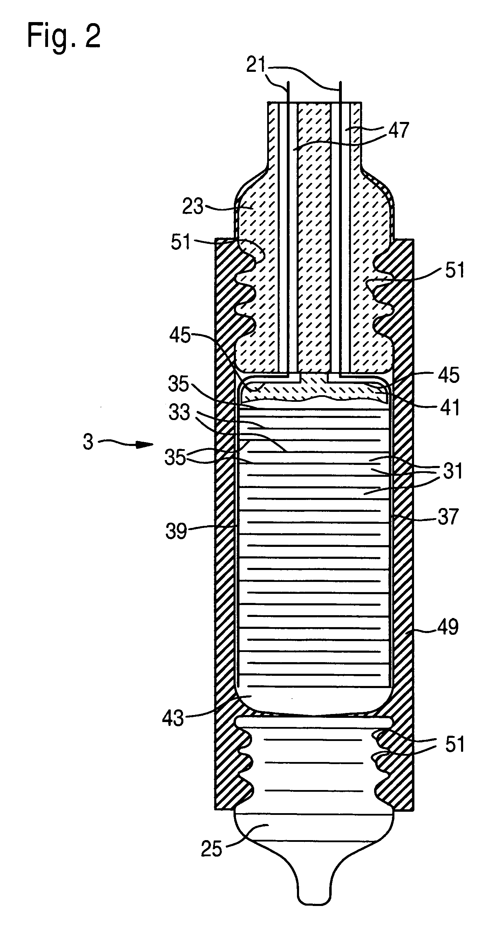

In Figur 2 ist eine Ausgestaltung des piezoelektrischen Aktors 3 teilweise geschnitten dargestellt.

In dieser stark vergrößerten Darstellung des piezoelektrischen Aktors 3 wird deutlich, dass der eigentliche piezoelektrische Aktor aus mehreren Keramikschichten 31 aufgebaut ist, die aus Gründen der Übersichtlichkeit nicht alle mit Bezugszeichen versehen wurden. Zwischen den Keramikschichten 31 sind Elektrodenschichten 33 und 35 angeordnet. Auch hier sind aus Gründen der Übersichtlichkeit nicht alle Elektrodenschichten 33 und 35 mit Bezugszeichen versehen worden.

Die Elektrodenschichten 33 bilden eine erste Gruppe von Elektrodenschichten und sind mit einer ersten Außenelektrode 37 elektrisch leitend verbunden.

Die Elektrodenschichten 35 bilden eine zweite Gruppe von Elektrodenschichten und sind mit einer zweiten Außenelektrode 39 elektrisch leitend verbunden.

Oberhalb der in Figur 2 am weitesten oben angeordneten Elektrodenschicht 35 ist eine Deckschicht 41 geschnitten dargestellt. Diese erste Deckschicht 41 ist ebenso wie die unterhalb der untersten Elektrodenschicht 33 angeordnete zweite Deckschicht 43 dicker als die Keramikschichten 31. Sie bestehen ebenfalls aus einem keramischen Material. Üblicherweise bestehen sie aus dem gleichen keramischen Material wie die Keramikschichten 31. Die Deckschichten 41 und 43 leisten jedoch keinen Beitrag zum Hub des piezoelektrischen Aktors 3, da in ihnen kein elektrisches Feld zwischen einer Elektrodenschicht 33 und einer Elektrodenschicht 35 entsteht, wenn der piezoelektrische Aktor 3 bestromt wird.

In der Deckschicht 41 sind Vertiefungen 45 ausgespart, in denen die erste Außenelektrode 37 und die zweite Außenelektrode 39 geführt werden. Dies bedeutet, dass die Außenelektroden 37 und 39 an einer Stirnfläche des piezoelektrischen Aktors 3 enden.

In dem Fußteil 23 des piezoelektrischen Aktors 3 sind zwei Kabelführungen 47 vorgesehen. In den Kabelführungen 21 verlaufen die elektrischen Leitungen 21. Die elektrischen Leitungen 21 sind mit den Außenelektroden 37 und 39 im Bereich der Stirnfläche des piezoelektrischen Aktors 3 elektrisch leitend miteinander verbunden. Diese Art der Kontaktierung ist extrem belastbar, da die Kontaktstelle allseitig eingeschlossen ist; sei es durch die Deckschicht 41 des piezoelektrischen Aktors 3 oder durch das Fußteil 23 des piezoelektrischen Aktors 3.

Des Weiteren ist es, weil das Kopfteil 23 auch aus keramischem Material besteht, möglich, die elektrische Verbindung zwischen den elektrischen Leitungen 21 und den Außenelektroden 37 und 39 in dem gleichen Herstellungsprozess herzustellen, in dem auch die elektrische Verbindung zwischen den Elektrodenschichten 33 und 35 und den Außenelektroden 37 und 39 hergestellt wird. Dadurch ergibt sich eine Vereinfachung des Herstellungsprozesses und ein erhöhter Durchsatz.

In Figur 2 ist ein weiteres wesentliches Merkmal des piezoelektrischen Aktors 3 gut zu erkennen. Üblicherweise müssen die piezoelektrischen Aktoren flüssigkeitsdicht gegen die Umgebung abgedichtet werden. Dies erfolgt bei herkömmlichen Piezoaktoren dadurch, dass ein Metallgehäuse um den piezoelektrischen Aktor 3, das Kopfteil 23 und das Fußteil 25 herum angeordnet wird. Dieses Metallgehäuse muss selbstverständlich so elastisch sein, dass es den Hub des piezoelektrischen Aktors 3 übertragen kann, ohne zu brechen. Dieses Metallgehäuse ist sehr kostenintensiv und verschlechtert die elektromagnetische Verträglichkeit.

Bei dem Piezoaktor 3 sind der piezoelektrische Aktor 3, das Kopfteil 25 und das Fußteil 23 von einem Mantel 49 umgeben. Dieser Mantel 49 umschließt den piezoelektrischen Aktor 3 vollständig und das Fußteil 23 sowie das Kopfteil 25 teilweise. Der Mantel 49 kann beispielsweise durch Umspritzen von Fußteil 23, Kopfteil 25 und piezoelektrischem Aktor 3 mit Gummi oder einem elastischen Kunststoff erfolgen. Alternativ ist es auch möglich, dass der Mantel 49 durch einen Schrumpfschlauch gebildet wird, der in gestrecktem Zustand über das Fußteil 23, den piezoelektrischen Aktor 3 und das Kopfteil 25 geschoben wird. Anschließend wird der Schrumpfschlauch erhitzt und zuieht sich infolgedessen zusammen. Dadurch entsteht eine Abdichtung des piezoelektrischen Aktors 3, die flüssigkeitsdicht und ausreichend elastisch ist.

Um die Verbindung zwischen dem Mantel 49 einerseits und dem Fußteil 23 sowie dem Kopfteil 25 andererseits noch belastbarer zu gestalten, sind sowohl im Fußteil 23 als auch im Kopfteil 25 mehrere Umfangsnuten 51 vorgesehen. Diese Umfangsnuten 51 ermöglichen eine formschlüssige Verbindung zwischen dem Mantel 49 und dem Fußteil 23 sowie dem Kopfteil 25.

## Patentansprüche

1. Injektor für ein Kraftstoffeinspritzsystem einer Brennkraftmaschine, mit einem Gehäuse (1), wobei in dem Gehäuse (1) ein piezoelektrischer Aktor (3),ein hydraulisches Steuerventil (7) und ein Düsenmodul (9) mit einer Düsennadel (11) angeordnet sind, wobei sich der piezoelektrische Aktor (3) einenends mindestens mittelbar gegen das Gehäuse (1) abstützt, wobei sich der piezoelektrische Aktor (3) anderenends mindestens mittelbar gegen das Steuerventil (7) abstützt, und wobei zwischen piezoelektrischem Aktor (3) und Steuerventil (7) eine Einstellplatte (27) vorgesehen ist, **dadurch gekennzeichnet, dass** die Einstellplatte (27) aus einem keramischen Material besteht.

2. Injektor nach Anspruch 1, **dadurch gekennzeichnet, dass** zwischen dem piezoelektrischen Aktor (3) und dem Gehäuse (1) ein Distanzstück (29) aus einem keramischen Material vorgesehen ist.

3. Injektor nach einem der Ansprüche 1 oder 2, **dadurch gekennzeichnet, dass** die Einstellplatte (27) und/oder das Distanzstück (29) aus Aluminiumoxid besteht.

## Claims

1. Injector for a fuel injection system of an internal combustion engine, having a housing (1), with a piezoelectric actuator (3), a hydraulic control valve (7) and a nozzle module (9) which has a nozzle needle (11) being arranged in the housing (1), with the piezoelectric actuator (3) being supported at one end at least indirectly against the housing (1), with the piezoelectric actuator (3) being supported at the other end at least indirectly against the control valve (7), and with an adjusting plate (27) being provided between the piezoelectric actuator (3) and the control valve (7), **characterized in that** the adjusting plate (27) is composed of a ceramic material.

2. Injector according to Claim 1, **characterized in that** a spacer (29) composed of a ceramic material is provided between the piezoelectric actuator (3) and the housing (1).

3. Injector according to one of Claims 1 and 2, **characterized in that** the adjusting plate (27) and/or the spacer (29) are/is composed of aluminium oxide.

## Revendications

1. Injecteur pour un système d'injection de carburant d'un moteur à combustion interne, comprenant un boîtier (1), où un actionneur piézoélectrique (3), une soupape de commande (7) et un module de buse (9) avec une aiguille de buse (11) sont disposés dans le boîtier (1), l'actionneur piézoélectrique (3) s'appuyant à une extrémité au moins de manière indirecte contre le boîtier (1), l'actionneur piézoélectrique (3) s'appuyant à l'autre extrémité au moins de manière indirecte contre la soupape de commande (7), et une plaque d'ajustement (27) étant prévue entre l'actionneur piézoélectrique (3) et la soupape de commande (7), **caractérisé en ce que** la plaque d'ajustement (27) se compose d'un matériau céramique.

2. Injecteur selon la revendication 1, **caractérisé en ce qu'**un élément d'espacement (29) en matériau céramique est prévu entre l'actionneur piézoélectrique (3) et le boîtier (1).

3. Injecteur selon l'une quelconque des revendications 1 ou 2, **caractérisé en ce que** la plaque d'ajustement (27) et/ou l'élément d'espacement (29) se composent d'oxyde d'aluminium.
